# EUROPEAN PATENT SPECIFICATION

(11) **EP 1 416 326 B1**
(45) Date of publication and mention of the grant of the patent: **11.06.2008**
(21) Application number: 03256755.4
(22) Date of filing: 27.10.2003
(51) Int. Cl.: G03F 7/20

(54) **Method, inspection system, computer program and reference substrate for detecting mask defects**
Verfahren, Inspektionssystem, Rechnerprogramm und Referenzsubstrat zum Erkennen von Maskenfehlern
Méthode, système d'inspection, logiciel et substrat de référence pour la détection de défauts de masque

(30) Priority: 28.10.2002 EP 02257465
(43) Date of publication of application: 06.05.2004
(73) Proprietor: ASML Netherlands B.V., 5504 DR Veldhoven (NL)
(72) Inventor: Van der Werf, Jan Evert, 5581 JG Waalre (NL); Mud, Auke Jan, 5346 WR Oss (NL)
(74) Representative: Leeming, John Gerard

(56) References cited:
- WO-A-20/04008244
- US-A- 5 812 563
- US-A1- 2002 121 915
- US-B1- 6 252 412
- US-B1- 6 426 168
- PATENT ABSTRACTS OF JAPAN vol. 1998, no. 08, 30 June 1998 (1998-06-30) & JP 10 062964 A (NEC CORP), 6 March 1998 (1998-03-06)

## Description

The present invention relates to a method of detecting errors in patterning means used in photolithographic apparatus comprising:
- a radiation system for supplying a projection beam of radiation;
- a support structure for supporting patterning means, the patterning means serving to pattern the projection beam according to a desired pattern;
- a substrate table for holding a substrate; and
- a projection system for projecting the patterned beam onto a target portion of the substrate.

The term "patterning means" as here employed should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:
- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired.
- A programmable mirror array. One example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam
- becomes patterned according to the addressing pattern of the matrix-addressable surface. An alternative embodiment of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-addressable mirrors. The required matrix addressing can be performed using suitable electronic means. In both of the situations described hereabove, the patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096). In the case of a programmable mirror array, the said support structure may be embodied as a frame or table, for example, which may be fixed or movable as required.
- A programmable LCD array. An example of such a construction is given in United States Patent US 5,229,872, which is incorporated herein by reference. As above, the support structure in this case may be embodied as a frame or table, for example, which may be fixed or movable as required.
For purposes of simplicity, the rest of this text may, at certain locations, specifically direct itself to examples involving a mask and mask table; however, the general principles discussed in such instances should be seen in the broader context of the patterning means as hereabove set forth.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (*e.g.* comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper. In an alternative apparatus -commonly referred to as a step-and-scan apparatus - each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792, incorporated herein by reference.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4, incorporated herein by reference.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Dual stage lithographic apparatus are described, for example, in US 5,969,441 and WO 98/40791.

Defects in the mask, or mask pattern can result in defective devices, such as ICs, and are therefore undesirable. Mask defects typically fall into three categories. Firstly, contamination, such as dirt or stains, on a transparent or reflective part of the mask can block and/or distort exposing radiation and print onto the substrate as though it were a part of the pattern. Secondly, cracks in the mask material (e.g. quartz) can block or scatter radiation, therefore causing distorted images. Thirdly, pattern distortions in the mask manufacturing process may occur. These distortions include pinholes, chrome spots, pattern extensions, missing parts, breaks in the pattern and bridges between adjacent patterns. Of the three sources of defects, contamination is the most prevalent and to minimize the possibility of contamination the mask is usually kept in clean conditions during use. Often pellicles are also used on a mask to minimize or eliminate contaminants on the mask after the pellicle is installed.

To avoid manufacturing defective devices, a defective mask should be detected as soon as possible so that it can be repaired or replaced. Conventionally, when a defect in the mask and/or mask pellicle is suspected or as part of maintenance, the mask is removed from the lithographic apparatus and examined. If the mask and/or pellicle is undamaged the mask is returned to the apparatus and production continues. If the mask and/or pellicle is damaged, the mask and/or pellicle is repaired or replaced and then returned to the lithographic apparatus. However, in removing a mask from the lithographic apparatus, the mask and pellicle are subjected to increased probabilities of contamination and/or damage. Additionally, in checking for defects, production of devices will slow or cease and it is therefore advantageous for inspection and examination to be as fast as possible, without compromising accuracy.

US-B1-6 252 412 discloses a method for detecting defects in a patterned substrate comprising operating a charged-particle-beam optical column to acquire images over multiple sub-areas of the patterned substrate by scanning a charged-particle beam over the patterned substrate. A comparison is made between the acquired images and a reference to identify defects in the patterned substrate.

US-B1-6 426 168 discloses a method of inspecting photo masks by patterning at least one image in a first region of a substrate using a first photo mask, and patterning at least one second image in a second region of the substrate using a second photo mask. A comparison is made between the first and second images to determine if the first photo mask forms a pattern substantially similar to the image formed by the second mask.

WO 2004/008244 A is relevant only in the sense of Article 54(3) EPC. It discloses a method comprising acquiring aerial images of a reticle for different values of a member of a set of lithographic variables. A method is disclosed for determining the presence of an anomaly in a design pattern of the reticle by comparing at least one pair of the aerial images corresponding to at least two of the different values.

It is an object of the present invention to provide an improved method of detecting defects in patterning means.

This and other objects are achieved according to the invention in a method according to claim 1.

As exposure of a patterning means can take place with the patterning means in situ i.e. in clean conditions in the lithographic apparatus, the patterning means is no longer subjected to increased possibility of contamination or damage through removal and replacement. Furthermore, because the patterning means (e.g. the mask) does not need to be removed from the clean conditions unnecessarily, device throughput is virtually unaffected. Exposure of a test substrate takes the same time as exposure of a production substrate and any further inspection of the test substrate can take place while production continues.

Methods of photolithography are well developed and so the inventors have found a substrate comprising a silicon wafer with a layer of SiO₂ to be a good reference substrate. A wafer with a nitride layer can also be a good reference substrate. As will be apparent to those skilled in the art, other materials can be used, for example to yield an accurate pattern with strong contrast. Photolithographic methods used to manufacture devices can then be employed and a highly accurate pattern etched into the SiO₂ or other layer.

To avoid contamination, both the reference substrate and the patterning means should be stored in clean conditions. According to an embodiment of the invention, the patterning means need only be removed from clean conditions when a defect is detected.

For convenient comparison, the test substrate can be the reference substrate. In particular, the test substrate is patterned by exposing a layer of radiation sensitive material (resist). Once the test substrate has been scanned, the resist can be removed, and the test substrate reused.

The reference pattern is preferably printed at a plurality of different locations on the reference substrate, with sufficient space between each reference pattern to allow individual test patterns to be printed beside each of the reference patterns.

In order to compare a reference pattern and a test pattern, e.g. by means of a visual comparison, the patterned test substrate and reference substrate can be scanned by at least one optical defect inspection tool, possibly simultaneously. The optical defect inspection tool could be, for example, a microscope or a system using Scanning Electron Microscopy, such as KLA inspection systems (e.g. KLA-Tencor's 2139 system or KLA=Tencor's ES20 series). Multiple comparisons between reference and test patterns may be performed and majority voting can determine the location of the defect.

As used herein, the terms "print" and "printed" comprise exposure Those terms may also comprise exposure and development of a resist or exposure, development of a resist and etching. Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of electromagnetic radiation, including ultraviolet radiation (*e.g.* with a wavelength of 365, 248, 193, 157 or 126 nm) and EUV (extreme ultra-violet radiation, *e.g.* having a wavelength in the range 5-20 nm), as well as particle beams, such as ion beams or electron beams.

Embodiments of the invention will now be described, by way of example only, with reference to the accompanying schematic drawings in which:
Figure 1 depicts a lithographic projection apparatus according to an embodiment of the invention;
Figure 2 depicts an arrangement of reference patterns and test patterns on a combined reference substrate and test substrate; and

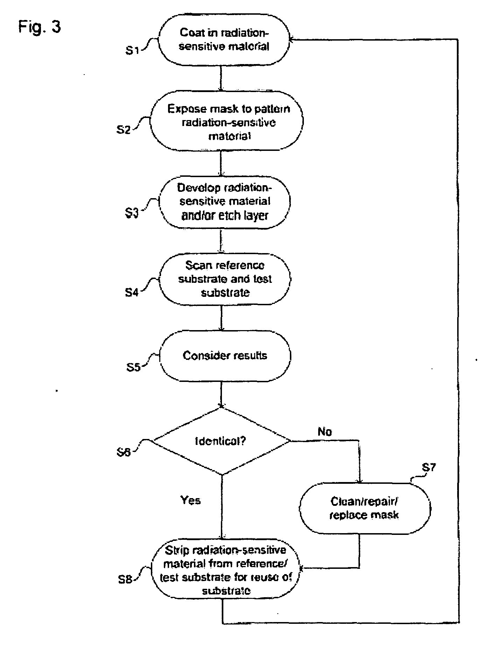

Figure 3 is a flow diagram of a method of testing for a defect in patterning means according to an embodiment of the invention.

In the Figures, corresponding reference symbols indicate corresponding parts.

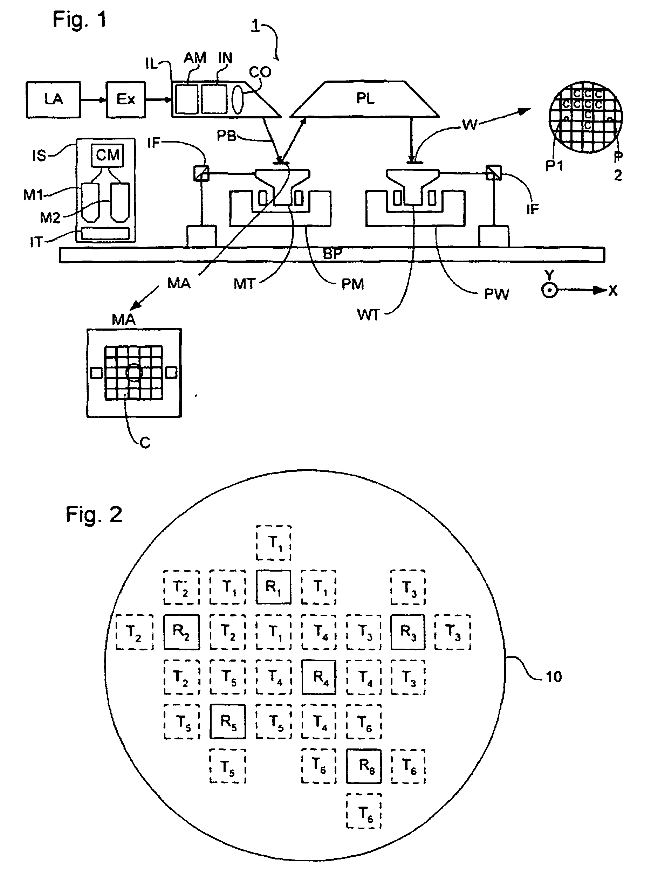

Figure 1 schematically depicts a lithographic projection apparatus which is used in the invention. The apparatus comprises:
· a radiation system Ex, IL, for supplying a projection beam PB of radiation (*e.g.* EUV radiation), which in this particular case also comprises a radiation source LA;
· a first object table (mask table) MT provided with a mask holder for holding a mask MA (*e.g.* a reticle), and connected to first positioning means for accurately positioning the mask with respect to item PL;
· a second object table (substrate table) WT provided with a substrate holder for holding a substrate W (*e.g.* a resist-coated silicon wafer), and connected to second positioning means for accurately positioning the substrate with respect to item PL;
· a projection system ("lens") PL (*e.g.* a refractive lens system group) for imaging an irradiated portion of the mask MA onto a target portion C (*e.g.* comprising one or more dies) of the substrate W;
· an inspection system IS.
As here depicted, the apparatus is of a reflective type (*e.g.* has a reflective mask). However, in general, it may also be of a transmissive type, for example (*e.g.* with a transmissive mask). Alternatively, the apparatus may employ another kind of patterning means, such as a programmable mirror array of a type as referred to above.

The source LA (*e.g.* a laser-produced or discharge plasma source) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to Figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (e.g. with the aid of suitable directing mirrors); this latter scenario is often the case when the source LA is an excimer laser. The current invention and claims encompass both of these scenarios.

The beam PB subsequently intercepts the mask MA, which is held on a mask table MT. Having traversed by the mask MA, the beam PB passes through the lens PL, which focuses the beam PB onto a target portion C of the substrate W. With the aid of the second positioning means (and interferometric measuring means IF), the substrate table WT can be moved accurately, *e.g.* so as to position different target portions C in the path of the beam PB. Similarly, the first positioning means can be used to accurately position the mask MA with respect to the path of the beam PB, *e.g.* after mechanical retrieval of the mask MA from a mask library, or during a scan. In general, movement of the object tables MT, WT will be realized with the aid of a long-stroke module (course positioning) and a short-stroke module (fine positioning), which are not explicitly depicted in Figure 1. However, in the case of a wafer stepper (as opposed to a step-and-scan apparatus) the mask table MT may just be connected to a short stroke actuator, or may be fixed.

The depicted apparatus can be used in two different modes:
1. In step mode, the mask table MT is kept essentially stationary, and an entire mask image is projected at once (*i.e*. a single "flash") onto a target portion C. The substrate table WT is then shifted in the x and/or y directions so that a different target portion C can be irradiated by the beam PB;
2. In scan mode, essentially the same scenario applies, except that a given target portion C is not exposed in a single "flash". Instead, the mask table MT is movable in a given direction (the so-called "scan direction", *e.g.* the y direction) with a speed *v*, so that the projection beam PB is caused to scan over a mask image; concurrently, the substrate table WT is simultaneously moved in the same or opposite direction at a speed *V* = *Mv*, in which *M* is the magnification of the lens PL (typically, *M* = 1/4 or 1/5). In this manner, a relatively large target portion C can be exposed, without having to compromise on resolution.

A mask is assumed undamaged and clean when first installed in a lithographic apparatus and according to this embodiment of the present invention a reference substrate 10 is printed after installation of the mask by exposing a pattern of the mask onto the reference place. The reference substrate is printed substantially directly after installation of the mask. The reference substrate 10 provides an "idealized" pattern with which to compare future possibly defective patterns. In this embodiment the reference substrate 10 is formed from a silicon substrate with an outer layer of SiO₂ of known purity and thickness. The substrate is coated with a resist. To print the reference substrate 10, the mask, already installed in the lithographic apparatus but not yet used in the production of devices such as ICs, is used to pattern a projection beam to expose the resist. As shown in Figure 2, one or more substantially identical reference patterns R₁, R₂, R₃, R₄... are exposed spaced apart. The resist material is developed to reveal the SiO₂ beneath, which is then etched, e.g. using hydrofluoric acid. When the remaining resist is removed the pattem(s) is/are revealed as an etched pattern(s) in the SiO₂. The reference substrate 10 is then kept in clean conditions until it is needed.

When, for example, a defect is suspected, the reference substrate 10 is coated in resist, step S 1. In step S2 the mask patterns the projection beam to expose the resist in order to print substantially identical test patterns, T₁, T₂, T₃, T₄... on the reference/test substrate next to the reference patterns R₁, R₂, R₃, R₄.... After developing the resist and etching the exposed SiO₂ in step S3, the reference pattern and the test pattern of each pair are scanned by one or more respective microscopes simultaneously or in sequence in step S4. Depending on the resist type, the layer stack etc. the sensitivity of the microscope, or other inspection tool, is adjusted to obtain the highest contrast in the reference and test patterns. Meanwhile the lithographic apparatus can continue production. In S5 and S6 the results of the scans of T₁ and R₁ are considered to see if they are identical. If they are not identical there may be a defect in the mask, or alternatively there may be a random error in the single exposure of pattern T₁ or R₁. T₂ and R₂ may therefore be compared and if these are identical then it is assumed the difference between T₁ and R₁ was due to a random error and the mask is defect free. If T₂ and R₂ are not identical T₃ and R₃ and T₄ and R₄ etc. can be compared. Majority voting can be employed with respect to the comparisons of T₁ and R₁, T₂ and R₂, T₃ and R₃ etc. to determine if there is a defect. If a defect is present, T₁ and R₁ can be scanned in more detail to determine the exact location of the defect, by determining which small area of T₁ and R₁ is non-identical. In step S7 the mask is removed from the apparatus and cleaned, repaired or replaced if a defect is suspected. The reference/test substrate can be reused by printing test patterns T₁, T₂, T₃, T₄... on different locations adjacent or near to the reference patterns R₁, R₂, R₃, R₄.... The reference substrate 10 is returned to storage in clean conditions.

The above system is configured using a computer which uses details such as the pattern layout, layer stack and resist type to optimize the system. Furthermore the computer program may manage the arrangement of reference and test patterns on the reference and test substrates respectively.

In the above embodiments, the reference substrate 10 is the test substrate, but the invention is not limited to this, and the reference and test substrates can be different. Where the reference substrate and test substrate are different substrates, the reference substrate is printed with one or more reference patterns R₁, R₂, R₃, etc. This reference substrate is then used for comparison with one or more test substrates. A separate test substrate is then printed for comparison with the reference substrate. When comparison is complete, the resist on the test substrate can be stripped so that the test substrate can be reused for additional test patterns.

In the above embodiment, the reference and test substrate have been exposed, developed and etched before scanning by a microscope. Optionally, the reference and test substrates may also simply be exposed or exposed and developed, particularly where the reference and test substrate are different substrates. Alternatively, a surface other than SiO₂ which would give a pattern with good contrast could be used. The inventors have found a layer of nitride on the silicon to be particularly good.

In an embodiment, the patterning means is an EUV mask, such as a reflective mask.

While specific embodiments of the invention have been described above, it will be appreciated that the invention may be practiced otherwise than as described. The description is not intended to limit the invention.

## Claims

1. A method of detecting defects in a patterning means (MA) comprising:
installing the patterning means (MA) in a lithographic apparatus;
using the patterning means (MA) in a photolithographic process to expose a pattern for manufacture of a device on a production substrate (W);
**characterised by** further comprising:
using the patterning means (MA) in a photolithographic process to print a reference pattern on a reference substrate (10) different from said production substrate;
storing the reference substrate (10) in clean conditions after the printing of the reference pattern;
using the patterning means (MA) in a photolithographic process to print a test pattern on a test substrate; and
comparing the printed test pattern to the printed reference pattern to detect a defect in the patterning means (MA).

2. A method of detecting defects in a patterning means (MA) according to claim 1, wherein the reference substrate (10) is a silicon wafer.

3. A method of detecting defects in a patterning means (MA) according to any one of the preceding claims, wherein the reference substrate (10) is a silicon wafer having an SiO₂ layer and the printed reference pattern is etched into the SiO₂ layer.

4. A method of detecting defects in a patterning means (MA) according to any one of the preceding claims, wherein the test substrate is the reference substrate (10).

5. A method of detecting defects in a patterning means (MA) according to any one of the preceding claims, wherein the printed test pattern is a pattern in developed resist.

6. A method of detecting defects in a patterning means (MA) according to any one of the preceding claims, wherein the reference pattern is printed at a plurality of different locations on the reference substrate (10).

7. A method of detecting defects in a patterning means (MA) according to claim 6, wherein individual printed reference pattern are spaced such that an individual test pattern can be printed beside each individual printed reference pattern.

8. A method of detecting defects in a patterning means (MA) according to any one of the preceding claims, wherein in comparing the printed test pattern to the printed reference pattern the patterned test substrate and reference substrate (10) are scanned by at least one optical defect inspection tool.

9. A method of detecting defects in a patterning means (MA) according to claim 8, wherein in comparing the printed test pattern to the printed reference pattern the patterned test substrate and reference substrate (10) are scanned simultaneously by respective optical defect inspection tools.

10. A method of detecting defects in a patterning means (MA according to either claim 8 or claim 9, wherein multiple comparisons take place between multiple printed reference pattern and multiple printed test pattern.

11. A method of detecting defects in a patterning means (MA) according to claim 10, wherein majority voting determines location of the defect in the patterning means (MA).

12. A method of detecting defects in a patterning means (MA) according to any one of the preceding claims, wherein said patterning means (MA) is a photolithography mask.

13. A method according to claim 4, wherein the reference substrate (10) is coated with resist before the using of the patterning means (MA) to print a reference pattern on the reference substrate (10), wherein the resist is developed and the printed reference pattern is revealed after printing of the reference pattern on the reference substrate (10) and before the printing of the test pattern on the reference substrate (10).

14. A method according to claim 13, wherein the reference substrate (10) is being kept in clean condition after the printing and revealing of the reference pattern and before the printing of the test pattern on the reference substrate (10).

15. A method according to claim 13 or 14, wherein the reference substrate (10) is being coated in resist after the revealing of the printed reference pattern and before the printing of the test pattern on the reference substrate (10).

16. A method according to claim 1, wherein the patterning means (MA) are used in a photolithographic process to print the reference pattern on the reference substrate with the patterning means (MA) already installed in the lithographic apparatus but not yet used in the production of devices.

17. A method according to claim 1, wherein exposure of the patterning means takes place with the patterning means *in situ*, i.e. in clean conditions in a lithographic apparatus; and wherein the patterning means are removed from the clean conditions when a defect is detected.

## Patentansprüche

1. Verfahren zum Erkennen von Fehlern in einer Musteraufbringungseinrichtung (MA), das folgendes umfasst:
• Installieren der Musteraufbringungseinrichtung (MA) in einer lithographischen Vorrichtung;
• Verwenden der Musteraufbringungseinrichtung (MA) in einem photolithographischen Verfahren, um ein Muster zur Herstellung eines Bauelements auf ein Herstellungssubstrat (W) zu belichten;
**dadurch gekennzeichnet, dass** es ferner umfasst:
• Verwenden der Musteraufbringungseinrichtung (MA) in einem photolithographischen Verfahren, um ein Referenzmuster auf ein Referenzsubstrat (10) aufzudrucken, das sich vom Herstellungssubstrat unterscheidet;
• Aufbewahren des Referenzsubstrats (10) in reiner Umgebung, nachdem das Referenzmuster gedruckt worden ist;
• Verwenden der Musteraufbringungseinrichtung (MA) in einem photolithographischen Verfahren, um ein Testmuster auf ein Testsubstrat aufzudrucken; und
• Vergleichen des gedruckten Testmusters mit dem gedruckten Referenzmuster, um einen Fehler in der Musteraufbringungseinrichtung (MA) zu erkennen.

2. Verfahren zum Erkennen von Fehlern in einer Musteraufbringungseinrichtung (MA) nach Anspruch 1, wobei das Referenzsubstrat (10) ein Silizium-Wafer ist.

3. Verfahren zum Erkennen von Fehlern in einer Musteraufbringungseinrichtung (MA) nach einem der vorhergehenden Ansprüche, wobei das Referenzsubstrat (10) ein Silizium-Wafer ist, der eine SiO₂-Schicht aufweist und das gedruckte Referenzmuster in die SiO₂-Schicht eingeätzt ist.

4. Verfahren zum Erkennen von Fehlern in einer Musteraufbringungseinrichtung (MA) nach einem der vorhergehenden Ansprüche, wobei das Testsubstrat das Referenzsubstrat (10) ist.

5. Verfahren zum Erkennen von Fehlern in einer Musteraufbringungseinrichtung (MA) nach einem der vorhergehenden Ansprüche, wobei das gedruckte Testmuster ein Muster in entwickelter Schutzschicht ist.

6. Verfahren zum Erkennen von Fehlern in einer Musteraufbringungseinrichtung (MA) nach einem der vorhergehenden Ansprüche, wobei das Referenzmuster bei einer Vielzahl von unterschiedlichen Stellen auf das Referenzsubstrat (10) gedruckt ist.

7. Verfahren zum Erkennen von Fehlern in einer Musteraufbringungseinrichtung (MA) nach Anspruch 6, wobei einzelne gedruckte Referenzmuster so beabstandet sind, dass ein einzelnes Testmuster neben jedes einzelne gedruckte Referenzmuster gedruckt werden kann.

8. Verfahren zum Erkennen von Fehlern in einer Musteraufbringungseinrichtung (MA) nach einem der vorhergehenden Ansprüche, wobei während des Vergleichs des gedruckten Testmusters mit dem gedruckten Referenzmuster das gemusterte Testsubstrat und das Referenzsubstrat (10) von wenigstens einem optischen Inspektionstool für Fehler abgetastet wird.

9. Verfahren zum Erkennen von Fehlern in einer Musteraufbringungseinrichtung (MA) nach Anspruch 8, wobei während des Vergleichs des gedruckten Testmusters mit dem gedruckten Referenzmuster das gemusterte Testsubstrat und das Referenzsubstrat (10) simultan von jeweiligen optischen Inspektionstools für Fehler abgetastet wird.

10. Verfahren zum Erkennen von Fehlern in einer Musteraufbringungseinrichtung (MA) nach Anspruch 8 oder 9, wobei mehrere Vergleiche zwischen mehreren gedruckten Referenzmustern und mehreren gedruckten Testmustern stattfinden.

11. Verfahren zum Erkennen von Fehlern in einer Musteraufbringungseinrichtung (MA) nach Anspruch 10, wobei die Stelle des Fehlers in der Musteraufbringungseinrichtung (MA) durch Mehrheitsauswahl bestimmt ist.

12. Verfahren zum Erkennen von Fehlern in einer Musteraufbringungseinrichtung (MA) nach einem der vorhergehenden Ansprüche, wobei die Musteraufbringungseinrichtung (MA) eine photolithographische Maske ist.

13. Verfahren nach Anspruch 4, wobei das Referenzsubstrat (10) mit einer Schutzschicht bedeckt wird, bevor die Musteraufbringungseinrichtung (MA) verwendet wird, um ein Referenzmuster auf das Referenzsubstrat (10) zu drucken, wobei die Schutzschicht entwickelt wird und das gedruckte Referenzmuster freigelegt wird, nachdem das Referenzmuster auf das Referenzsubstrat (10) gedruckt worden ist und bevor das Testmuster auf das Referenzmuster (10) gedruckt wird.

14. Verfahren nach Anspruch 13, wobei das Referenzsubstrat (10) nach dem Drucken und dem Freilegen des Referenzmusters und vor dem Drucken des Testmusters auf das Referenzsubstrat (10) in reiner Umgebung belassen wird.

15. Verfahren nach Anspruch 13 oder 14, wobei das Referenzsubstrat (10) nach dem Freilegen des gedruckten Referenzmusters und vor dem Drucken des Testmusters auf das Referenzmuster (10) mit Schutzlack beschichtet wird.

16. Verfahren nach Anspruch 1, wobei die Musteraufbringungseinrichtungen (MA) bei einem photolithographischen Verfahren verwendet werden, um das Referenzmuster auf das Referenzsubstrat zu drucken, wobei die Musteraufbringungseinrichtungen (MA) bereits in der lithographischen Vorrichtung installiert sind, bei der Herstellung von Bauelementen jedoch noch nicht verwendet werden.

17. Verfahren nach Anspruch 1, wobei die Belichtung der Musteraufbringungseinrichtungen in situ mit den Musteraufbringungseinrichtungen stattfindet, d.h. in reiner Umgebung in einer lithographischen Vorrichtung; und wobei die Musteraufbringungseinrichtungen aus der reinen Umgebung entfernt werden, sobald ein Fehler erkannt worden ist.

## Revendications

1. Procédé pour détecter des défauts dans des moyens de mise en forme (MA) comprenant :
l'installation des moyens de mise en forme (MA) dans un appareil lithographique ;
l'utilisation des moyens de mise en forme (MA) dans un processus photolithographique pour exposer un motif pour la fabrication d'un dispositif sur un substrat de production (W) ;
**caractérisé en ce qu'**il comprend en outre :
l'utilisation des moyens de mise en forme (MA) dans un processus photolithographique pour imprimer un motif de référence sur un substrat de référence (10) différent dudit substrat de production ;
le stockage du substrat de référence (10) dans des conditions de propreté après l'impression du motif de référence ;
l'utilisation des moyens de mise en forme (MA) dans un processus photolithographique pour imprimer un motif de test sur un substrat de test ; et
la comparaison du motif de test imprimé au motif de référence imprimé pour détecter un défaut dans les moyens de mise en forme (MA).

2. Procédé pour détecter des défauts dans des moyens de mise en forme (MA) selon la revendication 1, dans lequel le substrat de référence (10) est une plaquette de silicium.

3. Procédé pour détecter des défauts dans des moyens de mise en forme (MA) selon l'une quelconque des revendications précédentes, dans lequel le substrat de référence (10) est une plaquette de silicium ayant une couche de SiO₂ et le motif de référence imprimé est gravé dans la couche de SiO₂.

4. Procédé pour détecter des défauts dans des moyens de mise en forme (MA) selon l'une quelconque des revendications précédentes, dans lequel le substrat de test est le substrat de référence (10).

5. Procédé pour détecter des défauts dans des moyens de mise en forme (MA) selon l'une quelconque des revendications précédentes, dans lequel le motif de test imprimé est un motif dans une réserve développée.

6. Procédé pour détecter des défauts dans des moyens de mise en forme (MA) selon l'une quelconque des revendications précédentes, dans lequel le motif de référence est imprimé à une pluralité d'emplacements différents sur le substrat de référence (10).

7. Procédé pour détecter des défauts dans des moyens de mise en forme (MA) selon la revendication 6, dans lequel des motifs de référence imprimés individuels sont espacés de telle sorte qu'un motif de test individuel peut être imprimé à côté de chaque motif de référence imprimé individuel.

8. Procédé pour détecter des défauts dans des moyens de mise en forme (MA) selon l'une quelconque des revendications précédentes, dans lequel en comparant le motif de test imprimé au motif de référence imprimé, le substrat de test et le substrat de référence (10) mis en forme sont balayés par au moins un outil d'inspection de défauts optiques.

9. Procédé pour détecter des défauts dans des moyens de mise en forme (MA) selon la revendication 8, dans lequel en comparant le motif de test imprimé au motif de référence imprimé, le substrat de test et le substrat de référence (10) mis en forme sont balayés simultanément par des outils respectifs d'inspection de défauts optiques.

10. Procédé pour détecter des défauts dans des moyens de mise en forme (MA) selon l'une des deux revendications 8 ou 9, dans lequel de multiples comparaisons ont lieu entre de multiples motifs de référence imprimés et de multiples motifs de test imprimés.

11. Procédé pour détecter des défauts dans des moyens de mise en forme (MA) selon la revendication 10, dans lequel un vote à la majorité détermine l'emplacement du défaut dans les moyens de mise en forme (MA).

12. Procédé pour détecter des défauts dans des moyens de mise en forme (MA) selon l'une quelconque des revendications précédentes, dans lequel lesdits moyens de mise en forme (MA) sont un masque de photolithographie.

13. Procédé selon la revendication 4, dans lequel le substrat de référence (10) est revêtu de réserve avant d'utiliser les moyens de mise en forme (MA) pour imprimer un motif de référence sur le substrat de référence (10), dans lequel la réserve est développée et le motif de référence imprimé est révélé après l'impression du motif de référence sur le substrat de référence (10) et avant l'impression du motif de test sur le substrat de référence (10).

14. Procédé selon la revendication 13, dans lequel le substrat de référence (10) est maintenu dans des conditions de propreté après l'impression et la révélation du motif de référence et avant l'impression du motif de test sur le substrat de référence (10).

15. Procédé selon la revendication 13 ou 14, dans lequel le substrat de référence (10) est revêtu de réserve après la révélation du motif de référence imprimé et avant l'impression du motif de test sur le substrat de référence (10).

16. Procédé selon la revendication 1, dans lequel les moyens de mise en forme (MA) sont utilisés dans un processus photolithographique pour imprimer le motif de référence sur le substrat de référence, les moyens de mise en forme (MA) étant déjà installés dans l'appareil lithographique mais non encore utilisés dans la production de dispositifs.

17. Procédé selon la revendication 1, dans lequel une exposition des moyens de mise en forme (MA) a lieu avec les moyens de mise en forme in situ, c'est-à-dire dans des conditions de propreté dans un appareil lithographique ; et dans lequel les moyens de mise en forme sont retirés des conditions de propreté lorsqu'un défaut est détecté.
